Europäisches Patentamt

European Patent Office

Office européen des brevets

(19)

(11) **EP 0 815 660 B1**

(12) **EUROPÄISCHE PATENTSCHRIFT**

(45) Veröffentlichungstag und Bekanntmachung des Hinweises auf die Patenterteilung:
**16.12.1998 Patentblatt 1998/51**

(21) Anmeldenummer: **96905705.8**

(22) Anmeldetag: **09.03.1996**

(51) Int Cl.$^6$: **H04B 14/04**, H04L 1/20, H04J 3/14, G01R 29/26, H04L 1/24

(86) Internationale Anmeldenummer:
**PCT/DE96/00428**

(87) Internationale Veröffentlichungsnummer:
**WO 96/29789 (26.09.1996 Gazette 1996/43)**

(54) **VERFAHREN ZUR QUALITÄTSÜBERWACHUNG VON QUANTISIEREN IN DIGITALEN TONRUNDFUNK-ODER FERNSEHÜBERTRAGUNGSSYSTEMEN**

PROCESS FOR MONITORING THE QUANTISATION QUALITY IN DIGITAL RADIO OR TELEVISION TRANSMISSION SYSTEMS

PROCEDE DE SURVEILLANCE DE LA QUALITE DE QUANTIFICATION DANS DES SYSTEMES NUMERIQUES DE TRANSMISSION RADIO OU TELEVISION

(84) Benannte Vertragsstaaten:
**CH DE ES GB IT LI**

(30) Priorität: **17.03.1995 DE 19509117**

(43) Veröffentlichungstag der Anmeldung:
**07.01.1998 Patentblatt 1998/02**

(73) Patentinhaber: **ROBERT BOSCH GMBH**
**70442 Stuttgart (DE)**

(72) Erfinder: **MAYER, Joerg**
**D-70374 Stuttgart (DE)**

(56) Entgegenhaltungen:
**EP-A- 0 030 383**          **EP-A- 0 069 972**
**DE-A- 2 945 034**

- **SIEMENS/TELCOM REPORT, Bd. 10, Nr. 3, März 1987, MUNCHEN DE, Seiten 267-274, XP002008827 K. RAUCHENECKER / G. WESS: "Neue Messgerätegeneration für Digitalübertragungseinrichtungen."**

**Beschreibung**

Die Erfindung betrifft ein Verfahren zur Überwachung der Übertragungsqualität digitalisierter Signale, die einer Quantisierung unterzogen wurden.

Stand der Technik

Für die Messung des Signal-Rauschabstandes beispielsweise von einem digitalisierten Fernsehbild können Referenzsignale, z.B. die Prüfzeilen im Fernsehbild herangezogen werden. Diese Vorgehensweise setzt jedoch einen aufwendigen und teuren Prüfempfänger mit entsprechender Meßtechnik voraus. Die Überwachung von Pilotsignalen erfordert einen ähnlichen Aufwand.

Aus der EP-A-0-030 383 ist ein Verfahren zur Ermittlung der Quantisierungeverzerrungen von Übertragungseinrichtungen bekannt. Sendeseitig wird dort ein bestimmtes Frequenzband zur Verfügung gestellt und in die Übertragungseinrichtung eingespeist. Empfangsseitig erfolgt sowohl eine Pegelmessung innerhalb des sendeseitigen Frequenzbandes als auch eine Messung außerhalb dieses Frequenzbandes. Aus der Pegeldifferenz dieser beiden Messungen wird der Quantisierungs-Geräusch-Abstand ermittelt.

Aus der EP-A-0 069 972 ist im Verfahren zur Bestimmung der Signal- und der Verzerrungsleistung bekannt. Es werden zwei Signale erzeugt. Das erste Digitalsignal wird direkt zur Empfangsseite übertragen, das zweite Signal wird zuvor einem Codec zugeleitet. Aus Abtastproben der empfangenen Signale wird die Verzerrungsleistung bestimmt. Die DE-A-2 945 034 zeigt eine Anordnung zum Messen des Verhältnisses von Signal- zu Quantisierungsverzerrungen auf. Es wird mittels zweier Pegelmesser die Differenz zwischen einem Referenzsignal und einem die Quantisierungsverzerrung beinhaltenden Rauschsignal ermittelt.

Vorteile der Erfindung

Mit den Maßnahmen der Erfindung gemäß den Merkmalen des Hauptanspruchs können digitalisierte Signale während der Übertragung auf einfache Weise bezüglich ihrer Übertragungsqualität beurteilt werden. Eine Betriebsunterbrechung ist nicht erforderlich. Es kann auf einfache Weise beurteilt werden, ob ein im Übertragungsweg vorgesehener D/A-Wandler ordnungsgemäß arbeitet. In den Unteransprüchen sind vorteilhafte Weiterbildungen angegeben.

Die Erfindung beruht auf folgenden Erkenntnissen:

Die erreichbare Übertragungsqualität eines digitalisierten Signals, z.B. der Signal-Rauschabstand, ist direkt proportional zur Auflösung des zugehörigen im Übertragungsweg befindlichen D/A-Wandlers und der Einhaltung dessen Qualitätsparameter. Die Erfindung geht davon aus, daß bei der gleichförmigen Quantisierung eines Analogsignals bei der A/D-Wandlung bei ausreichender Aussteuerung (im allgemeinen > 6 Bit bei Sinusträger oder bei Mehrtonsignalen, wie sie bei Fernsehverteildiensten auftreten) durch die endliche Anzahl von Quantisierungsstufen, ein Fehler mit der Eigenschaft von weißem gaußförmigem Rauschen entsteht. Dieses weiße Rauschen ist über das ganze Nyquistspektrum gleich verteilt, also auch in jenen Frequenzbereichen, wo kein Nutzsignal übertragen wird. Durch Messung der Quantisierungsstörleistung, insbesondere ihrem Mittelwert, in diesen Bereichen kann die Quantisierungsstufe a für einen zugehörigen D/A-Wandler bestimmt werden und mit einem Erwartungswert verglichen werden. Ergibt sich zwischen der ermittelten Quantisierungsstufe a und dem Erwartungswert eine unzulässig große Differenz, wird ein Fehlersignal aufbereitet, welches beispielsweise über Fernwirkeinrichtungen zu einer zentralen Anzeige gebracht wird.

Es lassen sich so eine Vielzahl von D/A-Wandlern, beispielsweise in einem Fernsehverteilnetz während des Betriebes bezüglich ihrer Übertragungsqualität überwachen. Gleichzeitig können Erfahrungen über die Langzeitstabilität der D/A-Wandler gewonnen werden.

Zeichnungen

Anhand der Zeichnungen werden Ausführungsbeispiele der Erfindung näher erläutert. Es zeigen

Figur 1 ein Blockschaltbild für die Qualitätsüberprüfung eines D/A-Wandlers und
Figur 2 die Lage der Tonrundfunk- und Fernsehkanäle in einem Breitbandkommunikationsnetz.

Beschreibung

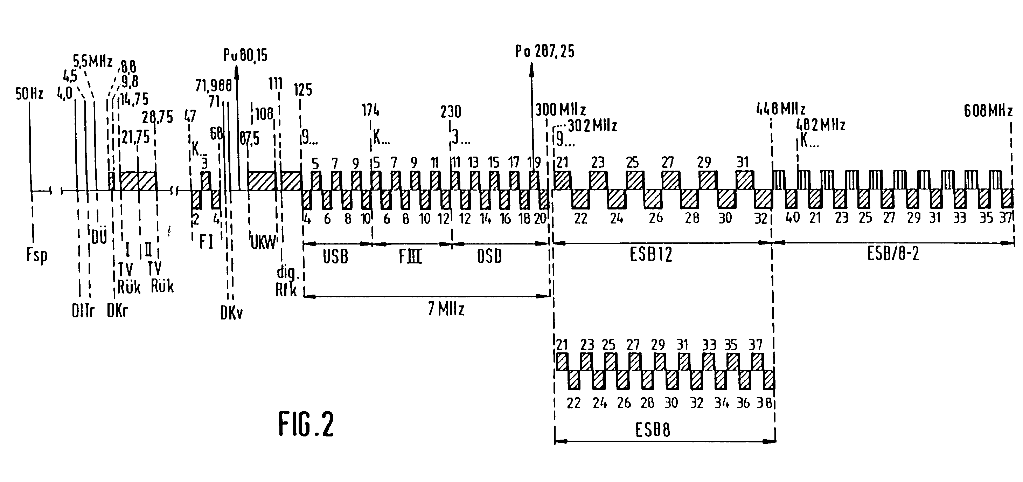

In einem Verteilnetz für Tonrundfunk- und Fernsehsignale werden die Rundfunk- und Fernsehsignale beispielsweise in Form eines digitalisierten Frequenzmultiplexsignal auf Glasfasern GF übertragen und beim Teilnehmer TLN mit Hilfe eines schnellen D/A-Wandlers in ein analoges Frequenzmultiplexsignal zurückgewandelt, das von handelsüblichen Rundfunk- und/oder Fernsehempfängern weiterverarbeitet werden kann. Ein Beispiel für das Frequenzmultiplexsignal ist in Figur 2 dargestellt.

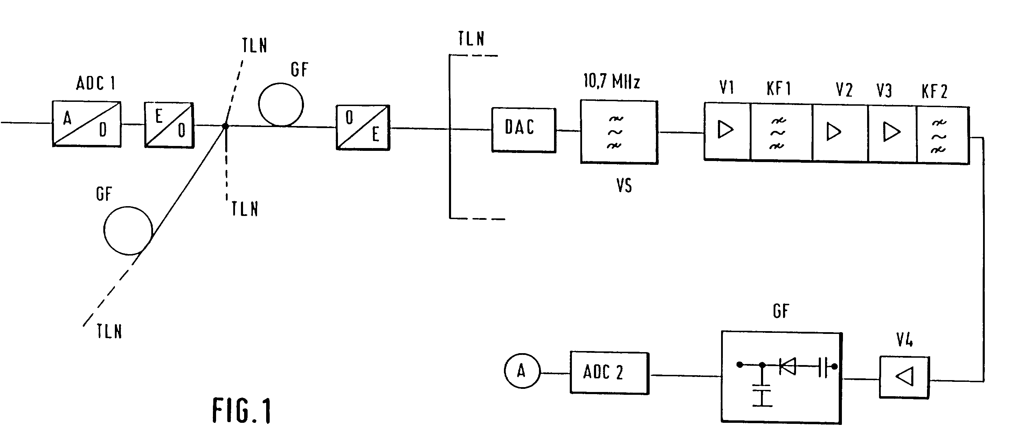

Da der Signal-Rauschabstand der digitalisierten, einer Quantisierung unterzogenen übertragenen Signale direkt proportional zur Auflösung des D/A-Wandlers ist, kann sich die Qualitätsüberprüfung auf diesen Parameter beschränken. Wie zuvor schon erwähnt, wird davon ausgegangen, daß bei der gleichförmigen Quantisierung eines Analogsignals bei der sendeseitigen A/D-Wandlung - ADC1 in Figur 1 - bei ausreichender Aussteuerung, im allgemeinen > 6 Bit bei Sinusträger oder Mehrtonsignalen, durch die endliche Anzahl der Quantisierungsstufen a, ein Fehler mit der Eigenschaft von weißem Rauschen entsteht. Für die mittlere Quantisierungsstörleistung oder Quantisierungsgeräuschleistung gilt allgemein (Vorlesungemanuskript Prof. Dr.Ing.

W. Kaiser, Übertragungstechnik II., Universität Stuttgart, 1982, Seiten 229 bis 230) :

$$P_q = \frac{a^2}{12}$$

wobei a einer Quantisierungsstufe entspricht.

Das hierdurch hervorgerufene Rauschen, das sich selbstverständlich zu anderen Rauschquellen, wie thermisches Rauschen, addiert, ist über das ganze Nyquistspektrum gleich verteilt, also auch an stellen, wo kein Nutzsignal übertragen wird. Durch Messung der mittleren Quantisierungsstörleistung, die natürlich größer sein muß als sonstige Rauschanteile, kann die Quantisierungsstufe a bestimmt werden.

Als eine Stelle, welche nicht vom Nutzspektrum belegt ist, *bietet sich* die Frequenz 10,7 MHz (oder auch 5,5 MHz oder 450kHz) an. Bei diesen Frequenzen läßt sich leicht ein empfindlicher hochselektiver Verstärker aufbauen, da entsprechende Filter erhältlich sind. Folgende Zahlenwerte gelten für ein realisiertes Fernsehverteilsytem. Bei einem D/A-Wandler mit einer Autlösung von 12 Bit und einer Ausgangsspannung von 1 Vss in 50 Ohm entspricht einer Quantisierungsstufe eine Spannung von

$$\frac{1\, Vss}{2^{12}} = 244\mu V.$$

Dem entspricht eine mittlere Quantisierungsstörleistung

$$P_q = \frac{a^2}{12} \triangleq 4,9\, e^{-9} W = \text{-76 dBm}.$$

Diese Störleitung verteilt sich über die gesamte Nyquistbandbreite, mithin also der halben Abtastfrequenz von

$$\frac{452\, MHz}{2} = 226\ \text{MHz}.$$

Da nur innerhalb einer Bandbreite von 300 kHz um 10,7 MHz um 5,5 MHz oder um 450 kHz gemessen wird, ist die zu erwartende Störleistung zu korrigieren um

$$10 \log \frac{300\, kHz}{226\, MHz} = \text{-28.,7 dBm}.$$

Die zu erwartende Störleistung bezogen auf eine Bandbreite von 300 kHz beträgt damit

$$P_{q300} = \text{-76 dBm - 28,7 dBm} = \text{-104,7 dBm}.$$

In dem realisierten Verteilsystem soll eine Verschlechterung des D/A-Wandlers auf 8 Bit erkannt werden. Die zu erwartende Störleistung eines 8 Bit D/A-Wandlers beträgt -104,7 dBm + 4 · 6 dBm = -80,7 dBm. Das Ausgangssignal des DAC gelangt über eine Vorselektion VS auf einen Verstärker V1 und dann auf ein erstes Keramikfilter KF1. In den Verstärkerstufen V2 und V3 erfolgt eine Pegelanhebung und Anpassung an ein zweites Keramikfilter KF2. Nach weiterer Verstärkung V4 steht das Rauschsignal mit einem Pegel von +4 dBm an einem Gleichrichter und Integrationsglied GF an. Ein A/D-Wandler ADC2 digitalisiert die Störspannung und leitet sie über eine entsprechende Schnittstelle an eine Systemsteuerung zur Auswertung A.

Zur Auswertung eignet sich im einfachsten Falle ein Komparator, der das auszuwertende Signal mit einem für den D/A-Wandler ermittelten Erwartungswert vergleicht. Ergibt sich im Ausführungsbeispiel eine Differenz ≥4, d.h. der Erwartungswert der Auflösung a = 12 wird um vier oder mehr als vier unterschritten, wird ein Fehlersignal aufbereitet und zur Anzeige gebracht.

Die vorgeschlagene Lösung ermöglicht eine einfache und preiswerte Überwachung des Signal-Rauschabstandes eines D/A-Wandlers im Betrieb. Weitere Einsparungen lassen sich durch Ersatz der Einzelverstärker durch handelsübliche ZF-Verstärker erreichen. Durch Wechsel der Keramikfilter läßt sich die Meßfrequenz verändern. Wird anstelle von Figur 1 ein durchstimmbares Vorfilter mit Oszillator und Mischstufe verwendet können beliebige Bereiche des Spektrums geprüft werden.

**Patentansprüche**

1. Verfahren zur Überwachung der Übertragungsqualität digitalisierter Signale, die einer Quantisierurg unterzogen wurden, wobei

   - die Quantisierungstörleistung in einem Bereich gemessen wird, wo kein Nutzsignal übertragen wird,

     gekennzeichnet durch folgende Schritte:

   - aus der Quantisierungsstörleistung wird die Quantisierungsstufe für einen zugehörigen D/A-Wandler bestimmt und mit einem Erwartungswert verglichen,
   - wenn die ermittelte Quantisierungsstufe vom Erwartungswert um eine vorgegebene zulässige Differenz abweicht, wird ein Fehlersignal aufbereitet.

2. Verfahren nach Anspruch 1, dadurch gekennzeichnet, daß für die Übertragung von digitalisierten Tonrundfunk- und/oder Fernsehsignalen eine Abweichung der ermittelten Quantisierungsstufe um 4 oder mehr als 4 vom Erwartungswert als Fehlersignal anzeigt wird.

3. Verfahren nach Anspruch 1 oder 2, dadurch gekennzeichnet, daß die Messung der Quantisierungsstörleistung in einem Fernsehsignalverteilnetz für Frequenzmultiplexsignale bei 10,7 MHz vorgenommen wird.

4. Verfahren nach Anspruch 3, dadurch gekennzeichnet, daß die Meßbandbreite zu 300 kHz gewählt wird.

**Claims**

1. Method for monitoring the quality of transmission of digitized signals which have been subjected to quantization, wherein

- the quantization noise power is measured in an area where no information signal is transmitted, being characterized by the following steps:
- the quantization level for an associated D/A converter is determined from the quantization noise power and compared with an expected value,
- if the quantization level found deviates from the expected value by a predetermined permissible difference, an error signal is prepared.

2. Method according to Claim 1, characterized in that a deviation by 4 or more than 4 from the expected value of the quantization level found is indicated as an error signal for the transmission of digitized sound broadcasts and/or television signals.

3. Method according to Claim 1 or 2, characterized in that the quantization noise power is measured at 10.7 MHz in a television signal distribution network for frequency-division multiplex signals.

4. Method according to Claim 3, characterized in that the measuring bandwidth is selected to be 300 kHz.

**Revendications**

1. Procédé servant à surveiller la qualité de transmission de signaux numériques qui sont soumis à une quantification, dans lequel

- on mesure la puissance de perturbation de la quantification dans une zone où aucun signal utile n'est transmis,

caractérisé par les étapes suivantes :

- on détermine, à partir de la puissance de perturbation de la quantification, l'étage de quantification pour un convertisseur numérique/analogique correspondant, et on le compare à une valeur attendue,
- quand l'étage de quantification déterminé s'écarte de la valeur attendue d'une différence prédéfinie autorisée, on prépare un signal d'erreur.

2. Procédé selon la revendication 1
caractérisé en ce que
pour la transmission de signaux numérisés de radio et/ou de télévision, on indique, comme signal d'erreur, un écart de l'étage déterminé de quantification de 4 ou plus de 4 fois la valeur attendue.

3. Procédé selon la revendication 1 ou 2,
caractérisé en ce que
la mesure de la puissance de perturbation de la quantification est effectuée dans un réseau de distribution de signaux de télévision pour des signaux multiplexés en fréquence à une fréquence de 10,7 MHz.

4. Procédé selon la revendication 3,
caractérisé en ce que
l'on choisit 300 kHz pour la largeur de bande de mesure.

EP 0 815 660 B1

FIG.1

50 Hz

5,5 MHz
4,5
4,0
8,8
9,8
14,75
21,75
28,75
DÜ
I    II
TV   TV
Rük  Rük
DITr   DKr

47
71,988
71
68
K...3
2    4
FI
Pu 80,15
87,5
108
111
UKW
125
dig. RIk
DKv

9...
5   7   9
4   6   8   10
USB

174
K...
5   7   9   11
6   8   10   12
FIII

230
3...
11  13  15  17  19
12  14  16  18  20
OSB

7 MHz

Po 287,25
300 MHz
302 MHz
9...
21   23   25   27   29   31
22   24   26   28   30   32
ESB12

448 MHz
482 MHz
K...
40  21  23  25  27  29  31  33  35  37
ESB/8-2

608 MHz

21  23  25  27  29  31  33  35  37
22  24  26  28  30  32  34  36  38
ESB8

Fsp

FIG.2

EP 0 815 660 B1

6